(19) Europäisches Patentamt
European Patent Office
Office européen des brevets

(11) EP 0 581 585 B1

(12) **EUROPEAN PATENT SPECIFICATION**

(45) Date of publication and mention
of the grant of the patent:
**15.10.1997 Bulletin 1997/42**

(51) Int Cl.⁶: **G02B 17/08**, G03F 7/20

(21) Application number: 93305960.2

(22) Date of filing: **28.07.1993**

(54) **Catadioptric reduction projection optical system**

Verkleinerndes katadioptrisches Projektionssystem

Système de projection en réduction catadioptrique

(84) Designated Contracting States:
**DE FR GB**

(30) Priority: **29.07.1992 JP 202359/92**

(43) Date of publication of application:
**02.02.1994 Bulletin 1994/05**

(73) Proprietor: **NIKON CORPORATION**
**Tokyo (JP)**

(72) Inventor: **Suenaga, Yutaka**
**Virunubu Hodogaya 624,**
**Kanagawa-ken, Japan (JP)**

(74) Representative: **Burke, Steven David et al**
**R.G.C. Jenkins & Co.**
**26 Caxton Street**
**London SW1H 0RJ (GB)**

(56) References cited:
**EP-A- 0 527 043          US-A- 3 285 128**
**US-A- 4 685 777          US-A- 4 747 678**
**US-A- 4 812 028**

**Description**

BACKGROUND OF THE INVENTION

Field of the Invention

The present invention relates to a catadioptric optical system having a reflection surface and a refraction surface, and more particularly to an image forming optical system for reduction projection.

Related Background Art

Various optical systems for projecting and exposing a mask pattern to a photoresist on a wafer to manufacture an integrated circuit such as an LSI have been proposed. It is known that an aberration is well corrected at a relatively large aperture in a Dyson type catadioptric optical system. However, since a focusing magnification in the Dyson type catadioptric optical system is unity, there is a limit in the transfer of a fine pattern.

As an optical system having a reduction factor suitable for the manufacture of a semiconductor device having a finer pattern, an optical system which is a modification of the Dyson type catadioptric optical system is disclosed in U. S. Patent 4,747,678 and U.S. Patent 4,953,960.

The optical system disclosed in U.S.P. 4,747,678 which permits the reduction projection allows the reduction focusing of a ring-shaped view field. Basically, it comprises three concave mirrors and a convex mirror and is used as a light exposure device for microlithography. Accordingly, it uses a very complex optical construction of a combination of a number of lenses.

The reduction projection optical system disclosed in U.S. Patent 4,953,960 comprises a combination of a concave mirror and a lens system. Since the reduction is attained by one time of focusing, the aberration is large and a combination of a number of lenses is needed to correct the aberration. Since it is essential to provide a large scale beam splitter such as a half mirror in a light path, a loss of light intensity is more than 75 % and the increase of exposure time due to the loss of light intensity causes a fatal shortcoming of the reduction of throughput in the manufacturing process of the semiconductor device. Further, a stray light which causes flare and ununiformity in illumination occurs in the large beam splitter in the light path, and it is difficult to manufacture a large semitransparent plane.

EP-A-0527043, published on 10 February 1993, is prior art by virtue of Article 54(3) EPC. It describes a catadioptric reduction optical system including a first partial optical system including a first group of lenses having a positive refractive power, a first concave reflection mirror and a second group of lenses having a positive refractive power, forming a primary reduced image of an object, a second partial optical system including a second concave reflection mirror and a third group of lenses having a positive refractive power, for further reducing the primary reduced image and refocusing it, and a reflection mirror arranged between the first partial optical system and the second partial optical system, arranged in sequence as viewed from the object.

SUMMARY OF THE INVENTION

It would be beneficial to provide a reduction projection optical system which solves problems encountered in the prior art optical system and which is simple in structure and has a good image-forming ability as a projection optical system for use in semiconductor fabrication.

The present invention is set out in the appended claims.

The catadioptric reduction projection optical system according to an embodiment of the present invention has, in succession from the objection side, a first partial optical system having a lens group $G_1$ of positive refractive power and a first concave reflecting mirror $M_1$ and for forming the primary reduced image of an object, a second partial optical system having a second concave reflecting mirror $M_2$ and a lens group $G_3$ of positive refractive power and for further reducing and re-imaging said primary reduced image, and a lens group $G_2$ disposed near said primary reduced image, and further has a reflecting mirror disposed in the optical path between said first concave reflecting mirror $M_1$ and said second concave reflecting mirror $M_2$ for bending the optical path.

In the catadioptric reduction projection optical according to the embodiment of the present invention described above, the first and second partial optical systems each have a concave reflecting mirror having chief refractive power and a lens group of positive refractive power and both make reduction imaging possible and therefore, a predetermined reduction magnification can be obtained as a whole system without each partial optical system being made to bear a great burden in aberration correction.

It is effective to make the construction of the first lens group $G_1$ into the so-called telephoto type comprising, in succession from the object side, a front group $G_{11}$ of positive refractive power and a rear group $G_{12}$ of negative refractive power. In this case, the reduction magnification in the first lens group $G_1$ can be earned and at the same time, the amount of aberration in the first concave reflecting mirror $M_1$ can be made small and therefore, it becomes unnecessary to obtain a reduction magnification by the second lens group $G_2$ and it becomes unnecesary to earn a reduction magnification by the second lens group $G_2$, and the second lens group $G_2$ can be used as a lens exclusively for aberration correction, and it becomes possible to endow it with a greater numerical aperture (N.A.). Accordingly, the second lens group $G_2$ can be made into a construction in which the second lens group is made to function as a lens group exclusively for aberration correction, near the primary reduced image.

Where each concave reflecting mirror is a spherical mirror, it is desirable that in the second partial optical system, a fourth lens group $G_4$ for aberration correction be disposed between the second concave mirror $M_2$ and the third lens group $G_3$. It is also effective to dispose, in the first partial optical system, a fifth lens group $G_5$ for aberration correction between the first lens group $G_1$ and the first concave reflecting mirror $M_1$.

In the manner described above, it is possible to be simple in optical construction and yet maintain an excellent imaging performance, and by having great numerical aperture (N.A.), the transfer of more minute patterns is possible.

In addition, in the optical system according to the present invention, a plane reflecting mirror $M_3$ for bending the optical path may be disposed in the optical path from the first partial optical system to the second partial optical system, and preferably between the first concave reflecting mirror $M_2$, whereby the optical path can be completely separate. Therefore, this reflecting mirror can be a total reflection mirror, and a beam splitter such as a half mirror is not required as is in the aforementioned U.S. Patent 4,953,960. This leads to the advantage that the loss of the quantity of light is much smaller and the possibility of creating harmful stray light such as flare is little.

Also, in the optical system of the present invention, all of the optical members, except the plane reflecting mirror $M_3$ for bending the optical path, have the centers of curvature on the same optical axis.

The essential difference of the construction of the present invention as described above from the optical system disclosed in the aforementioned U.S. Patent 4,747,678 is that a convex reflecting mirror is not required as an optical element. This is because the above-described optical system according to the prior art has adopted a correcting technique whereby negative Petzval sum created by the concave reflecting mirror is negated by the convex reflecting mirror and the refracting system effects auxiliary aberration correction, whereas the present invention adopts correcting technique whereby negative Petzval sum created by the concave reflecting mirror is negated by positive Petzval sum in the third lens group $G_3$ which is a lens group of positive refractive power. Therefore, in the present invention, the positive refractive power of the third lens group $G_3$ is made considerably strong and is positively used. Where the second lens group $G_2$ is a lens group of weak refractive power disposed near the primary reduced image $I_1$, it is possible to cause the second lens group $G_2$ to act as an aberration corrector.

Features of the present invention are now described in detail. The first and second partial optical systems are reduced image-forming systems as described above but the second concave reflection mirror $M_2$ in the second partial optical system preferably has a small magnification factor although it is close to unity magnification in order to facilitate the separation of the light path by the planar reflection mirror $M_3$. Specifically, it is preferable that the following condition is met:

$$-1.5 < \beta_{M2} < -1.0$$

where $\beta_{M2}$ is the magnification of the second concave reflection mirror $M_2$.

As a result, a position of an object image $I_1$ by the first partial optical system is closer to the second concave reflection mirror $M_2$ than a position of an image $I_2$ by the second partial optical system is so that the interference of the light path is prevented even for a light beam of a large numerical aperture. When $\beta_{M2}$ exceeds the upper limit, the magnification of the second concave reflection mirror exceeds unity and the separation of the light path is difficult to attain. Conversely, when the magnification exceeds the lower limit, it is difficult for the second partial optical system to attain the desired reduction factor, and the burden of the first partial optical system increases and a complex construction is required to correct the aberration.

The first concave reflection mirror $M_1$ has a relatively large reduction factor and plays an important role to balance the compactness of the entire system and the correction of aberration. It is preferable to meet the following condition.

$$-0.7 < \beta_{M1} < -0.3$$

where $\beta_{M1}$ is the reduction factor of the first concave reflection mirror $M_1$.

The balance of aberration of the groups of lenses is now discussed. The first group of lenses $G_1$ is arranged in the vicinity of the object surface and functions as a so-called view field lens and also corrects direction aberration. The second and third groups of lenses $G_2$ and $G_3$ have large positive refractive powers as described above, contribute to the formation of the reduced image and positively function to correct the Petzval sum and the negative distortion aberration generated therein is corrected by the positive distortion aberration of the first group of lenses $G_1$. The fourth group of lenses $G_4$ provisionally arranged in the second partial optical system is effective to correct higher order spherical aberration. Where the concave reflection mirrors, particularly the first concave reflection mirror $M_1$ which shares a large portion of the reduction factor are non-spherical rather than spherical, the fourth group of lenses $G_4$ may be omitted.

BRIEF DESCRIPTION OF THE DRAWINGS

Fig. 1 shows a light path of a first embodiment of a catadioptric reduction projection optical system of the present invention; and
Fig. 2 shows a light path of a second embodiment of the present invention.

DETAILED DESCRIPTION OF THE PREFERRED EMBODIMENTS

Preferred embodiments of the present invention are now explained.

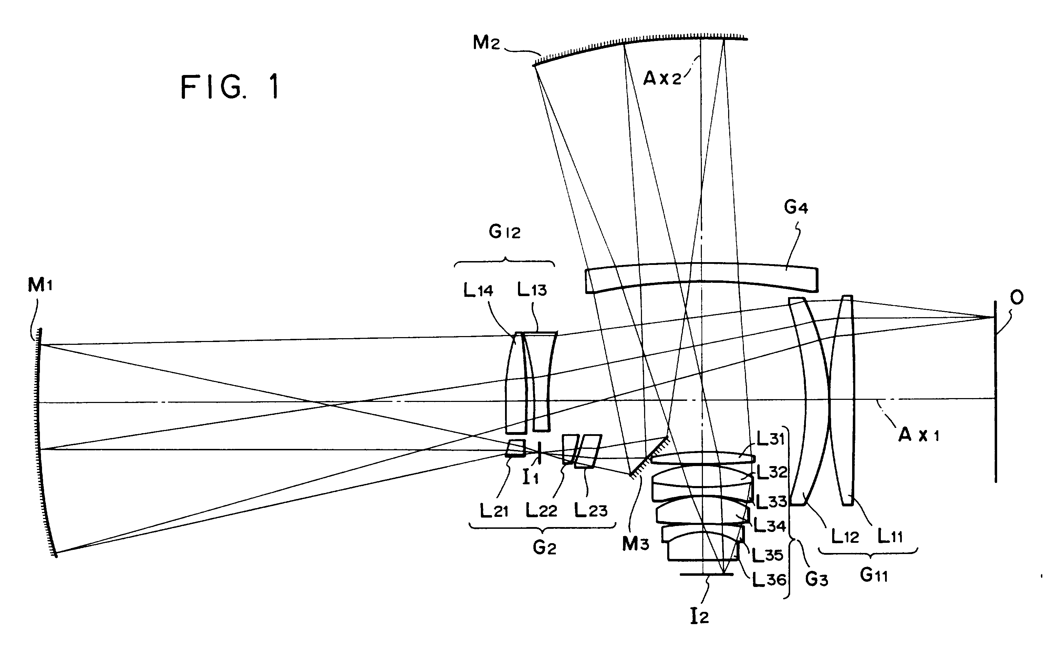

In a first embodiment of the present invention, as shown in Figure 1 the first lens group $G_1$ is comprised of a front group $G_{11}$ of positive refractive power having a positive lens $L_{11}$ having its surface of sharper curvature facing the image side and a positive meniscus lens $L_{12}$ having its convex surface facing the object side, and a rear group $G_{12}$ of negative refractive power having a biconcave negative lens $L_{13}$ and a positive lens $L_{14}$ having its surface of sharper curvature facing the image side. A reduction magnification can be earned by the first lens group $G_1$ constituting such a telephoto type and therefore, it becomes unnecessary to earn a reduction magnification in the second lens group $G_2$, which is comprised of a negative lens $L_{21}$ disposed immediately forwardly of the primary reduced image $I_1$, a positive lens $L_{22}$ disposed immediately rearwardly of the primary reduced image $I_1$ and a meniscus lens $L_{23}$ having its concave surface facing the primary reduced image $I_1$ side, and it is possible to effect the correction of off-axis aberrations well. Therefore, it becomes possible to make the numerical aperture (N.A.) greater.

The functions of the first concave reflecting mirror $M_1$, the plane reflecting mirror $M_3$ for bending the optical path and the second concave reflecting mirror $M_2$ are similar to the previous description, and the second concave reflecting mirror $M_2$ also has a magnification somewhat greater than the one-to-one magnification. The third lens group $G_3$ is of a somewhat complicated construction in order to effect good aberration correction for a greater numerical aperture. That is, a reduction magnification is given by the third lens group $G_3$ comprising two biconvex positive lenses $L_{31}$, $L_{32}$, a biconcave negative lens $L_{33}$, a positive lens $L_{34}$ having its surface of sharper curvature facing the second concave reflecting mirror $M_2$ side, a negative lens $L_{35}$ having its surface of sharper curvature facing the image side, and a positive lens $L_{36}$ having its surface of sharper curvature facing the second concave reflecting mirror $M_2$ side, and there is formed a secondary image $I_2$ more reduced than the primary image $I_1$. In this embodiment, a negative lens having weak negative refractive power as the fourth lens group $G_4$ is disposed between the second concave reflecting mirror $M_2$ and the third lens group $G_3$, whereby spherical aberration of high orders are corrected well.

In the construction of this first embodiment, the first lens group $G_1$, the first concave reflecting mirror $M_1$ and the negative lens $L_{21}$ in the second lens group $G_2$ can be regarded as constituting a first partial optical system, and the positive lens $L_{22}$ and the meniscus lens $L_{23}$ having its concave surface facing the primary reduced image $I_1$ side in the second lens group $G_2$, the second concave reflecting mirror $M_2$, the third lens group $G_3$ and the fourth lens group $G_4$ can be regarded as constituting a second partial optical system. On the other hand, the first lens group $G_1$ and the first concave reflecting mirror $M_1$ can be regarded as constituting the first partial optical system, the second concave reflecting mirror $M_2$, the third lens group $G_3$ and the fourth lens group $G_4$ can be regarded as constituting the second partial optical system, and relative to these, the second lens group $G_2$ for aberration correction can be regarded as being disposed near the primary reduced image $I_1$.

The rear group $G_{12}$ in the first lens group $G_1$ is provided only on one side of the optical axis Ax1 of the first partial optical system to make only the light travelling toward the first concave reflecting mirror $M_1$ diverge without intercepting the reflected light beam from the first concave reflecting mirror $M_1$. Also, the plane reflecting mirror $M_3$ for bending the optical path is obliquely disposed near the third lens group $G_3$ at an angle of 45° with respect to the optical axis Axl of the first partial optical system, and the optical axis Ax2 of the second partial optical system is made orthogonal to the optical axis Axl of the first partial optical system. This plane reflecting mirror $M_3$, as in the previously described embodiment, is near the primary image $I_1$ and therefore the size thereof is small, and this mirror can be installed in the space near the third lens group $G_3$.

Since the optical path of the second partial optical system is disposed between the front group $G_{11}$ and rear group $G_{12}$ in the first lens group $G_1$, the whole optical system can be made compact without waste of space. Also, of course the fourth lens group $G_4$ in the second partial optical system is provided so as not to interrupt the optical path of the first partial optical system.

Again this first embodiment has a reduction magnification +0.25 i.e., a reduction rate of one fourth, as a whole, and secures a zonal field of view having a radius of 25 mm from the optical axis, but has a great numerical aperture (N.A.) of 0.45.

The numerical data of the first embodiment are shown in a table below. In the table, it is to be understood that the signs of the refractive indices and the inter-surface spacings are reversed by the reflection on the concave reflecting mirror, and again here, the location of the third reflecting surface $M_3$ for bending the optical path is not essential in optical design and therefore is omitted.

## Table 1

### Numerical Data of the first Embodiment

| No. | Radius of curvature | Inter-surface spacing | Refractive index | | | |
|---|---|---|---|---|---|---|
| | (Object surface) | 179. 407 | 1. 000 | | | |
| 1 | 3465. 978 | 30. 000 | 1. 501 | $L_{11}$ | $G_{11}$ | $G_{11}$ |
| 2 | −528. 018 | 0. 100 | 1. 000 | | | |
| 3 . | 261. 503 | 31. 759 | 1. 501 | $L_{12}$ | | |
| 4 | 390. 000 | 316. 878 | 1. 000 | | | |
| 5 | −354. 698 | 17. 000 | 1. 501 | $L_{13}$ | $G_{12}$ | |
| 6 | 255. 219 | 11. 599 | 1. 000 | | | |
| 7 | 1186. 851 | 25. 883 | 1. 501 | $L_{14}$ | | |
| 8 | −281. 461 | 580. 467 | 1. 000 | | | |
| 9 | −766. 948 | −589. 210 | − 1. 000 | $M_1$ | | |
| 10 | 243. 085 | − 14. 000 | − 1. 501 | $L_{21}$ | $G_2$ | |
| 11 | 3114. 038 | − 50. 454 | − 1. 000 | | | |

| | | | | |
|---|---|---|---|---|
| 12 | − 3513. 309 | − 22. 000 | − 1. 501 | $L_{22}$ |
| 13 | 253. 255 | − 8. 618 | − 1. 000 | |
| 14 | 169. 996 | − 20. 000 | − 1. 501 | $L_{23}$ |
| 15 | 230. 045 | −270. 073 | − 1. 000 | |
| 16 | 642. 510 | − 23. 000 | − 1. 501 | $G_4$ |
| 17 | 1268. 362 | −277. 914 | − 1. 000 | |
| 18 | 659. 079 | 277. 914 | 1. 000 | $M_2$ |
| 19 | 1268. 362 | 23. 000 | 1. 501 | $G_4$ |
| 20 | 642. 510 | 208. 073 | 1. 000 | |
| 21 | 340. 589 | 16. 500 | 1. 501 | $L_{31}$   $G_3$ |
| 22 | −716. 211 | 20. 500 | 1. 000 | |
| 23 | 150. 058 | 26. 000 | 1. 501 | $L_{32}$ |
| 24 | −323. 551 | 1. 320 | 1. 000 | |
| 25 | −261. 398 | 9. 000 | 1. 501 | $L_{33}$ |
| 26 | 209. 855 | 0. 500 | 1. 000 | |
| 27 | 108. 115 | 34. 184 | 1. 501 | $L_{34}$ |
| 28 | −724. 878 | 0. 500 | 1. 000 | |
| 29 | 469. 777 | 9. 000 | 1. 501 | $L_{35}$ |
| 30 | 70. 411 | 1. 400 | 1. 000 | |
| 31 | 77. 096 | 34. 266 | 1. 501 | $L_{36}$ |
| 32 | −720. 000 | 15. 100 | 1. 000 | |

$$\beta_{M2} = -1.16$$

$$\beta_{M1} = -0.57$$

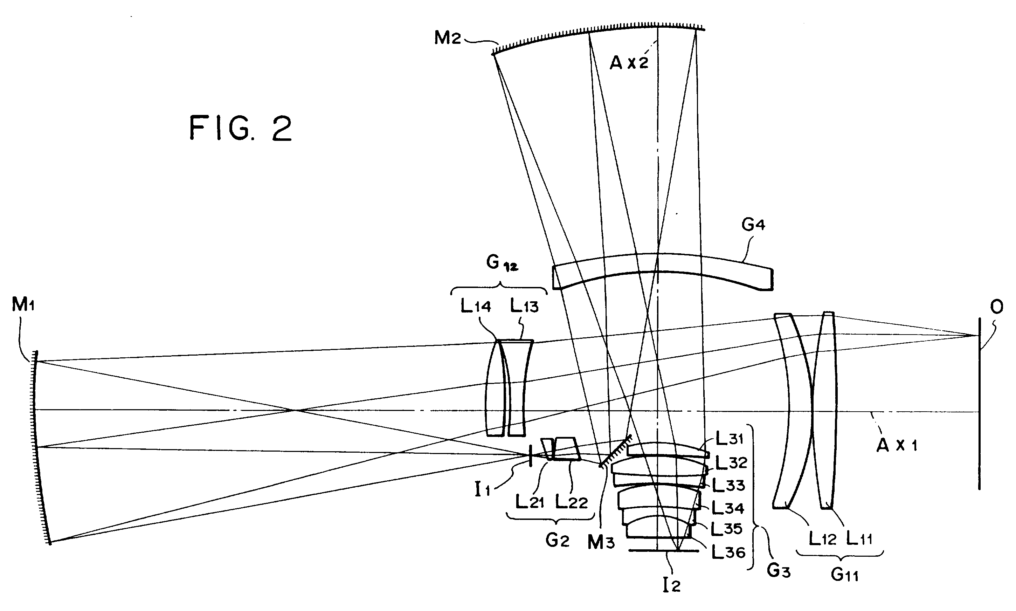

In a second embodiment of the present invention, as shown in Figure 2, the construction of the first lens group $G_1$ is basically similar to that in the first embodiment, but the second lens group $G_2$ is comprised of a positive lens $L_{21}$ and a biconcave negative lens $L_{22}$ disposed immediately rearwardly of the primary reduced image $I_1$, and no lens is present immediately forwardly of the primary reduced image $I_1$, i.e., between the first concave reflecting mirror $M_1$ adjacent to the first partial optical system and the primary reduced image $I_1$. In this embodiment, a reduction magnification is earned and aberration correction is sufficiently done in the first lens group $G_1$ comprising a front group $G_{11}$ of positive refractive power and a rear group $G_{12}$ of negative refractive power and therefore, the construction of the second lens group $G_2$ can be made simple.

6

The constructions of the other lens groups in this embodiment are substantial similar to those in the first embodiment.

Again this second embodiment has a reduction magnification +0.25, i.e., a reduction rate of one fourth, as a whole, and has a great numerical aperture (N.A.) of 0.45 in a zonal field of view having a radius of 25 mm from the optical axis.

The numerical data of the second embodiment are shown in Table 2 below.

## Table 2

### Numerical Data of the Second Embodiment

| No. | Radius of curvature | Inter-surface spacing | Refractive index | | | |
|---|---|---|---|---|---|---|
| | (Object surface) | 187.568 | 1.000 | | | |
| 1 | 1446.067 | 30.000 | 1.501 | $L_{11}$ | $G_{11}$ | $G_1$ |
| 2 | −640.000 | 0.100 | 1.000 | | | |
| 3 | 274.000 | 31.759 | 1.501 | $L_{12}$ | | |
| 4 | 390.000 | 345.240 | 1.000 | | | |
| 5 | −338.360 | 17.000 | 1.501 | $L_{13}$ | $G_{12}$ | |
| 6 | 273.442 | 7.464 | 1.000 | | | |
| 7 | 590.613 | 25.883 | 1.501 | $L_{14}$ | | |
| 8 | −281.411 | 589.287 | 1.000 | | | |
| 9 | −831.145 | −656.955 | −1.000 | $M_1$ | | |
| 10 | 180.000 | −23.000 | −1.501 | $L_{21}$ | $G_2$ | |
| 11 | −2908.427 | −5.005 | −1.000 | | | |
| 12 | −429.596 | −18.000 | −1.501 | $L_{22}$ | | |
| 13 | 197.384 | −292.451 | −1.000 | | | |
| 14 | 380.443 | −23.000 | −1.501 | $G_4$ | | |
| 15 | 596.210 | −294.291 | −1.000 | | | |
| 16 | 653.346 | 294.291 | 1.000 | $M_2$ | | |
| 17 | 596.210 | 23.000 | 1.501 | $G_4$ | | |
| 18 | 380.443 | 222.451 | 1.000 | | | |
| 19 | 153.779 | 17.000 | 1.501 | $L_{31}$ | $G_3$ | |
| 20 | 689.474 | 0.500 | 1.000 | | | |
| 21 | 156.334 | 26.500 | 1.501 | $L_{32}$ | | |

| 22 | −680.839 | 0.822 | 1.000 | |
| 23 | −508.366 | 9.000 | 1.501 | $L_{33}$ |
| 24 | 391.014 | 0.500 | 1.000 | |
| 25 | 143.155 | 29.818 | 1.501 | $L_{34}$ |
| 26 | 485.639 | 0.500 | 1.000 | |
| 27 | 267.611 | 9.000 | 1.501 | $L_{35}$ |
| 28 | 65.131 | 1.400 | 1.000 | |
| 29 | 66.963 | 28.952 | 1.501 | $L_{36}$ |
| 30 | −844.417 | 15.100 | 1.000 | |

$$\beta_{M2} = -1.17$$

$$\beta_{M1} = -0.55$$

In the above embodiments, the first concave reflection mirror $M_1$ and the second concave reflection mirrors $M_2$ are spherical although they may be non-spherical such as oval. In this case, the fourth group of lenses $G_4$ may be omitted as described above.

In accordance with the present invention, the catadioptric reduction projection optical system which is simpler in construction than the prior art optical system, and has a larger numerical aperture, a better image-forming ability and a wider illumination field or a wider exposure field is provided. In spite of the large numerical aperture and the wide exposure field, the plane accuracy and the allowance of eccentricity are less severe because of smaller size of the optical elements. Accordingly, it is very useful for a projection optical system for fabricating a semiconductor device.

## Claims

1. A catadioptric reduction projection optical system for forming the reduced image of an object, including in succession from the object side:

   a first sub-system having a first lens group ($G_1$) of positive refractive power and a first concave reflecting mirror ($M_1$) for forming a primary reduced image of the object;
   a second lens group ($G_2$) disposed near said primary reduced image; and
   a second sub-system having a second concave reflecting mirror ($M_2$) and a third lens group ($G_3$) of positive refractive power for further reducing and re-imaging said primary reduced image, characterized by
   said first lens group ($G_1$) having a front lens group ($G_{11}$) of positive refractive power and a rear lens group ($G_{12}$) of negative refractive power both disposed between said object and said first concave reflecting mirror ($M_1$),
   said third lens group ($G_3$) having a refractive power which is considerably stronger than that of said second lens group ($G_2$), and said third lens group correcting a negative Petzval sum created by said concave reflecting mirrors ($M_1$, $M_2$).

2. A catadioptric reduction projection optical system according to Claim 1, wherein said front lens group ($G_{11}$) of said first lens group ($G_1$) includes two positive lenses ($L_{11}$, $L_{12}$) and said rear lens group ($G_{12}$) of said first lens group ($G_1$) includes a negative lens ($L_{13}$) and a positive lens ($L_{14}$).

3. A catadioptric reduction projection optical system according to Claim 1, or 2, wherein said concave reflecting mirror

(M$_1$) of said first sub-system has a reduction factor and said concave reflecting mirror (M$_2$) of said second sub-system has a magnification factor.

4. A catadioptric reduction projection optical system according to any preceding claim, wherein said concave reflecting mirror (M$_2$) of said first sub-system has a magnification factor β$_{M2}$ which meets a condition of:

$$-1.5 < \beta_{M2} < -1.0$$

5. A catadioptric reduction projection optical system according to any preceding claim, wherein said concave reflecting mirror (M$_1$) of said second sub-system has a reduction factor β$_{M1}$ which meets a condition of:

$$-0.7 < \beta_{M1} < -0.3$$

6. A catadioptric reduction projection optical system according to any preceding claim, wherein a negative Petzval sum created in the concave reflecting mirror (M$_1$) of said first sub-system and the concave reflecting mirror (M$_2$) of said second sub-system is corrected by a positive Petzval sum created by the first lens group of said first sub-system and the second lens group of said second sub-system.

7. A catadioptric reduction projection optical system according to any preceding claim, further comprising a plane reflecting mirror (M$_3$) for altering the optical path, disposed in the optical path from the first sub-system to the second sub-system.

8. A catadioptric reduction projection optical system according to Claim 7, said plane reflection mirror (M$_3$) being disposed between said concave reflecting mirrors (M$_1$, M$_2$).

## Patentansprüche

1. Katadioptrisches optisches Verkleinerungs-Projektionssystem zur Erzeugung des verkleinerten Abbildes eines Objektes, umfassend, von der Objektseite aus, in dieser Reihenfolge:

   - ein erstes Subsystem mit einer ersten Linsengruppe (G$_1$) positiver Brechkraft und einem ersten konkaven Reflexionsspiegel (M$_1$) zur Erzeugung eines verkleinerten Primärbildes des Objekts,
   - eine zweite Linsengruppe (G$_2$), die nahe dem verkleinerten Primärbild angeordnet ist, und
   - ein zweites Subsystem mit einem zweiten konkaven Reflexionsspiegel (M$_2$) und einer dritten Linsengruppe (G$_3$) positiver Brechkraft zur weiteren Verkleinerung und zum erneuten Abbilden des verkleinerten Primärbildes, dadurch gekennzeichnet, daß
   - die erste Linsengruppe (G$_1$) eine vordere Linsengruppe (G$_{11}$) positiver Brechkraft und eine hintere Linsengruppe (G$_{12}$) negativer Brechkraft hat, die beide zwischen dem Objekt und dem ersten konkaven Reflexionsspiegel (M$_1$) angeordnet sind,
   - die dritte Linsengruppe (G$_3$) eine beträchtlich höhere Brechkraft als die zweite Linsengruppe (G$_2$) hat und die dritte Linsengruppe die negative Petzval-Summe korrigiert, die durch die konkaven Reflexionsspiegel (M$_1$, M$_2$) erzeugt wird.

2. Optisches System nach Anspruch 1, bei dem die vordere Linsengruppe (G$_{11}$) der ersten Linsengruppe (G$_2$) zwei Sammellinsen (L$_{11}$, L$_{12}$) hat und die hintere Linsengruppe (G$_{12}$) der ersten Linsengruppe (G$_1$) eine Zerstreuungslinse (L$_{13}$) und eine Sammellinse (L$_{14}$) einschließt.

3. Optisches System nach Anspruch 1 oder 2, bei dem der konkave Reflexionsspiegel (M$_1$) des ersten Subsystems einen Verkleinerungsfaktor und der konkave Reflexionsspiegel (M$_2$) des zweiten Subsystems einen Vergrößerungsfaktor hat.

4. Optisches System nach einem der vorangehenden Ansprüche, bei dem der konkave Reflexionsspiegel (M$_2$) des ersten Subsystems einen Vergrößerungsfaktor β$_{M2}$ hat, der die Bedingung erfüllt:

$$-1,5 < \beta_{M2} < -1,0.$$

**5.** Optisches System nach einem der vorangehenden Ansprüche, bei dem der konkave Reflexionsspiegel ($M_1$) des zweiten Subsystems einen Verkleinerungsfaktor $\beta_{M1}$ hat, der die Bedingung erfüllt:

$$-0,7 < \beta_{M1} < -0,3.$$

**6.** Optisches System nach einem der vorangehenden Ansprüche, bei dem die im konkaven Reflexionsspiegel ($M_1$) des ersten Subsystems und im konkaven Reflexionsspiegel ($M_2$) des zweiten Subsystems erzeugte negative Petzval-Summe durch eine durch die erste Linsengruppe des ersten Subsystems und die zweite Linsengruppe des zweiten Subsystems erzeugte positive Petzval-Summe korrigiert ist.

**7.** Optisches System nach einem der vorangehenden Ansprüche, weiterhin umfassend: einen der Änderung des optischen Weges dienenden ebenen Reflexionsspiegel ($M_3$), der im optischen Weg zwischen erstem Subsystem und zweitem Subsystem angeordnet ist.

**8.** Optisches System nach Anspruch 7, bei dem der ebene Reflexionsspiegel ($M_3$) zwischen den konkaven Reflexionsspiegeln ($M_1$, $M_2$) angeordnet ist.

**Revendications**

**1.** Système optique de projection en réduction catadioptrique pour former l'image réduite d'un objet, comprenant à la suite à partir du côté objet :

un premier sous-système ayant un premier groupe de lentilles ($G_1$) de pouvoir de réfraction positif et un premier miroir réfléchissant concave ($M_1$) pour former une image primaire réduite de l'objet, un deuxième groupe de lentilles ($G_2$) disposé à proximité de ladite image primaire réduite, et un second sous-système ayant un deuxième miroir réfléchissant concave ($M_2$) et un troisième groupe de lentilles ($G_3$) de pouvoir de réfraction positif pour encore réduire et reformer ladite image primaire réduite, caractérisé en ce que : ledit premier groupe de lentilles ($G_1$) comporte un groupe de lentilles avant ($G_{11}$) de pouvoir de réfraction positif et un groupe de lentilles arrière ($G_{12}$) de pouvoir de réfraction négatif, tous deux disposés entre ledit objet et ledit premier miroir réfléchissant concave ($M_1$), ledit troisième groupe de lentilles ($G_3$) a un pouvoir de réfraction qui est considérablement plus intense que celui dudit deuxième groupe de lentilles ($G_2$) et ledit troisième groupe de lentilles corrige une somme de Petzval négative créée par lesdits miroirs réfléchissants concaves ($M_1$, $M_2$).

**2.** Système optique de projection en réduction catadioptrique selon la revendication 1, dans lequel ledit groupe de lentilles avant ($G_{11}$) dudit premier groupe de lentilles ($G_1$) comprend deux lentilles positives ($L_{11}$, $L_{12}$) et ledit groupe de lentilles arrière ($G_{12}$) dudit premier groupe de lentilles ($G_1$) comprend une lentille négative ($L_{13}$) et une lentille positive ($L_{14}$).

**3.** Système optique de projection en réduction catadioptrique selon la revendication 1 ou 2, dans lequel ledit miroir réfléchissant concave ($M_1$) dudit premier sous-système a un facteur de réduction et ledit miroir réfléchissant concave ($M_2$) dudit second sous-système a un facteur d'agrandissement.

**4.** Système optique de projection en réduction catadioptrique selon l'une quelconque des revendications précédentes, dans lequel ledit miroir réfléchissant concave ($M_2$) dudit premier sous-système a un facteur d'agrandissement $\beta_{M2}$ qui satisfait à la condition :

$$-1,5 < \beta_{M2} < -1,0$$

**5.** Système optique de projection en réduction catadioptrique selon l'une quelconque des revendications précédentes, dans lequel ledit miroir réfléchissant concave ($M_1$) dudit second sous-système a un facteur de réduction $\beta_{M1}$ qui satisfait à la condition :

$$-0,7 < \beta_{M1} < -0,3$$

6. Système optique de projection en réduction catadioptrique selon l'une quelconque des revendications précédentes, dans lequel une somme de Petzval négative créée dans le miroir réfléchissant concave ($M_1$) dudit premier sous-système et le miroir réfléchissant concave ($M_2$) dudit second sous-système est corrigée par une somme de Petzval positive créée par le premier groupe de lentilles dudit premier sous-système et le deuxième groupe de lentilles dudit second sous-système.

7. Système optique de projection en réduction catadioptrique selon l'une quelconque des revendications précédentes, comprenant par ailleurs un miroir plan réfléchissant ($M_3$) pour modifier le trajet optique, disposé dans le trajet optique entre le premier sous-système et le second sous-système.

8. Système optique de projection en réduction catadioptrique selon la revendication 7, dans lequel ledit miroir plan réfléchissant ($M_3$) est disposé entre lesdits miroirs réfléchissants concaves ($M_1$, $M_2$).

FIG. 1

FIG. 2